# EUROPEAN PATENT APPLICATION

(11) **EP 4 486 093 A2**
(43) Date of publication of application: **01.01.2025**
(21) Application number: 24185093.2
(22) Date of filing: 27.06.2024
(51) Int. Cl.: H10K 59/122, H10K 59/80

(54) **DISPLAY DEVICE**

(30) Priority: 30.06.2023 KR 20230085046
(71) Applicant: Samsung Display Co., Ltd., Yongin-si, Gyeonggi-do 17113 (KR)
(72) Inventor: LEE, Joongu, Yongin-si (KR); GWARK, Hye Jin, Yongin-si (KR); KIM, Jaeik, Yongin-si (KR); KIM, Hwi, Yonigin-si (KR); PARK, Jungsun, Yongin-si (KR); LEE, Areum, Yongin-si (KR); LEE, Yeonhwa, Yongin-si (KR)
(74) Representative: Marks & Clerk LLP

(57) **Abstract**

A display device includes a circuit layer disposed on a base substrate, and a display element layer disposed on the circuit layer. The display element layer includes a light emitting element, a pixel defining layer defining a light emitting area of the light emitting element, a separator disposed on the pixel defining layer, and an auxiliary electrode disposed on the separator and including a reflective material. The auxiliary electrode is electrically connected to an electrode of the light emitting element, a side surface of the separator is inclined toward the light emitting element, and the auxiliary electrode covers the side surface of the separator.

## Description

### BACKGROUND

### 1. Technical Field

Embodiments of the disclosure described herein relate to a display device with improved reliability.

### 2. Description of the Related Art

Multimedia electronic devices such as a television, a mobile phone, a tablet computer, a navigation device, and a game console may include a display device for displaying an image. The display device may include a display panel including multiple pixels for displaying an image, and each of the pixels may include a light emitting element that generates light and a driving element connected to the light emitting element.

A display device having an organic light emitting element among the light emitting elements has advantages such as a wide viewing angle, a fast response speed, and a low power consumption, and thus, is drawing attention as a next-generation display device. However, there is a problem in that luminance non-uniformity occurs as an area of the display device increases.

### SUMMARY

Embodiments of the disclosure provide a display device with improved light emission efficiency.

According to an embodiment, a display device includes a circuit layer disposed on a base substrate, and a display element layer disposed on the circuit layer. The display element layer includes a light emitting element, a pixel defining layer defining a light emitting area of the light emitting element, a separator disposed on the pixel defining layer, and an auxiliary electrode disposed on the separator and including a reflective material. The auxiliary electrode is electrically connected to an electrode of the light emitting element, a side surface of the separator is inclined toward the light emitting element, and the auxiliary electrode covers the side surface of the separator.

In an embodiment, the auxiliary electrode may include an upper auxiliary electrode disposed on a top surface of the separator, and a side auxiliary electrode disposed on the side surface of the separator.

In an embodiment, a thickness of the upper auxiliary electrode and a thickness of the side auxiliary electrode may be different from each other.

In an embodiment, the thickness of the upper auxiliary electrode may be greater than the thickness of the side auxiliary electrode.

In an embodiment, a thickness of the side auxiliary electrode may become smaller as the side auxiliary electrode gets closer to the pixel defining layer.

In an embodiment, the display element layer may further include a lower auxiliary electrode disposed between the separator and the pixel defining layer.

In an embodiment, the auxiliary electrode and the lower auxiliary electrode may include a same material.

In an embodiment, the auxiliary electrode and the lower auxiliary electrode may be electrically connected to each other.

In an embodiment, the pixel defining layer may include a first pixel defining layer surrounding the light emitting area in a plan view, and a second pixel defining layer surrounded by the light emitting area in the plan view.

In an embodiment, the separator may include a first separator disposed on the first pixel defining layer, and a second separator disposed on the second pixel defining layer.

In an embodiment, the auxiliary electrode may be disposed on at least one of the first separator and the second separator.

In an embodiment, the auxiliary electrode may include a first auxiliary electrode disposed on the first separator, and a second auxiliary electrode disposed on the second separator, and the first auxiliary electrode and the second auxiliary electrode may be electrically connected to each other.

In an embodiment, the auxiliary electrode may include a metal.

In an embodiment, the light emitting element may include a first electrode, an intermediate layer disposed on the first electrode, and a second electrode electrically connected to the auxiliary electrode.

In an embodiment, the intermediate layer may be disconnected by the separator.

In an embodiment, the first electrode partially may overlap the pixel defining layer in a plan view.

In an embodiment, the pixel defining layer may include a light-transmissive material.

In an embodiment, an angle between the side surface of the separator and a top surface of the pixel defining layer may be in a range of about 70 ° to about 80 °.

In an embodiment, the circuit layer may include an auxiliary wire that applies a driving voltage to the light emitting element, and the auxiliary electrode and the auxiliary wire may be electrically connected to each other.

According to an embodiment, a display device includes a circuit layer disposed on a base substrate, a light emitting element disposed on the circuit layer and corresponding to a light emitting area, a partition wall disposed on the circuit layer and disposed to correspond to a non-light emitting area adj acent to the light emitting area, and an auxiliary electrode disposed on the partition wall and including a reflective material. The auxiliary electrode is electrically connected to an electrode of the light emitting element, and the partition wall includes a first partition wall surrounding the light emitting element in a plan view and a second partition wall surrounded by the light emitting element in the plan view. The auxiliary electrode is disposed on at least one of the first partition wall and the second partition wall.

In an embodiment, the partition wall may further include a pixel defining layer defining the light emitting area of the light emitting element, and a separator disposed on the pixel defining layer.

In an embodiment, a side surface of the separator may be inclined toward the light emitting element, and the auxiliary electrode may cover the side surface of the separator.

In an embodiment, an angle between the side surface of the separator and a top surface of the pixel defining layer may be in a range of about 70 ° to about 80 °.

In an embodiment, the light emitting element may include a first electrode, an intermediate layer disposed on the first electrode, and a second electrode electrically connected to the auxiliary electrode.

In an embodiment, the intermediate layer may be disconnected by the separator.

In an embodiment, the first electrode may partially overlap the pixel defining layer in the plan view.

In an embodiment, the pixel defining layer may include a light-transmissive material.

In an embodiment, the auxiliary electrode may include a first auxiliary electrode disposed on the first partition wall, and a second auxiliary electrode disposed on the second partition wall, and the first auxiliary electrode and the second auxiliary electrode may be electrically connected to each other.

According to an embodiment, a display device may include a circuit layer disposed on a base substrate, a light emitting element disposed on the circuit layer and corresponding to a light emitting area, a partition wall disposed on the circuit layer, disposed corresponding to a non-light emitting area adjacent to the light emitting area, and including a first portion and a second portion having a greater thickness than a thickness of the first portion, and an auxiliary electrode disposed on the second portion of the partition wall and containing a reflective material. The auxiliary electrode may be electrically connected to one electrode of the light emitting element.

At least some of the above and other features of the invention are set out in the claims.

### BRIEF DESCRIPTION OF THE DRAWINGS

The above and other objects and features of the disclosure will become apparent by describing in detail embodiments thereof with reference to the accompanying drawings.
FIG. 1 is a perspective view of a display device according to an embodiment of the disclosure.
FIG. 2 is an exploded perspective view of a display device according to an embodiment of the disclosure.
FIG. 3 is a schematic cross-sectional view of a display panel according to an embodiment of the disclosure.
FIG. 4 is a plan view of a display panel according to an embodiment of the disclosure.
FIG. 5 is a schematic diagram of an equivalent circuit of a pixel according to an embodiment of the disclosure.
FIG. 6 is an enlarged view of area AA' shown in FIG. 2.
FIG. 7 is a schematic cross-sectional view of a display panel taken along line I-I' in FIG. 6.
FIG. 8 is an enlarged view of area BB' shown in FIG. 7.
FIG. 9A is a schematic enlarged cross-sectional view of a separator and an auxiliary electrode according to an embodiment of the disclosure.
FIG. 9B is a schematic enlarged cross-sectional view of a separator, an auxiliary electrode, and a lower auxiliary electrode according to an embodiment of the disclosure.
FIG. 10 is a schematic cross-sectional view showing a portion of a display panel according to an embodiment of the disclosure.
FIG. 11A is an enlarged plan view of a portion of a display panel according to an embodiment of the disclosure.
FIG. 11B is a schematic cross-sectional view of a display panel taken along line II-II' in FIG. 11A.
FIG. 12A is a schematic enlarged cross-sectional view of a separator and an auxiliary electrode according to an embodiment of the disclosure.
FIG. 12B is a schematic enlarged cross-sectional view of a separator, an auxiliary electrode, and a lower auxiliary electrode according to an embodiment of the disclosure.

### DETAILED DESCRIPTION OF THE EMBODIMENTS

The disclosure may make various changes and have various forms. Therefore, specific embodiments are to be illustrated in the drawings and described in detail herein. However, this is not intended to limit the disclosure to the specific embodiments, and should be understood to include all changes, equivalents, or substitutes included in the technical scope of the disclosure.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Also, when an element is referred to as being "in contact" or "contacted" or the like to another element, the element may be in "electrical contact" or in "physical contact" with another element; or in "indirect contact" or in "direct contact" with another element.

Like reference numerals refer to like components. In addition, in the drawings, thicknesses, ratios, and dimensions of components are exaggerated for effective description of technical content.

In the specification and the claims, the phrase "at least one of" is intended to include the meaning of "at least one selected from the group of" for the purpose of its meaning and interpretation. For example, "at least one of A and B" may be understood to mean "A, B, or A and B." In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

Unless otherwise defined, all terms including technical and scientific terms used herein have the same meaning as commonly understood by one of ordinary skill in the art to which this disclosure belongs. In addition, terms, such as those defined in commonly used dictionaries, should be interpreted as having a meaning consistent with their meaning in the context of the relevant art, and are explicitly defined herein unless interpreted in an ideal or overly formal sense.

Hereinafter, embodiments of the disclosure will be described with reference to drawings.

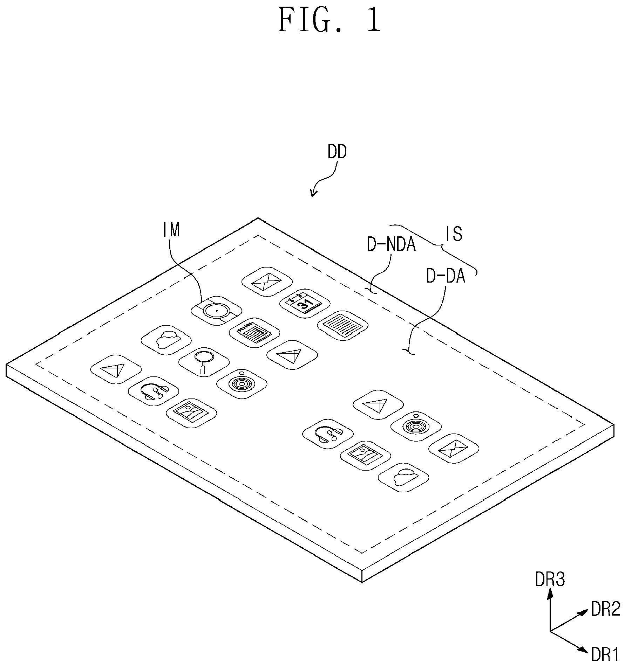

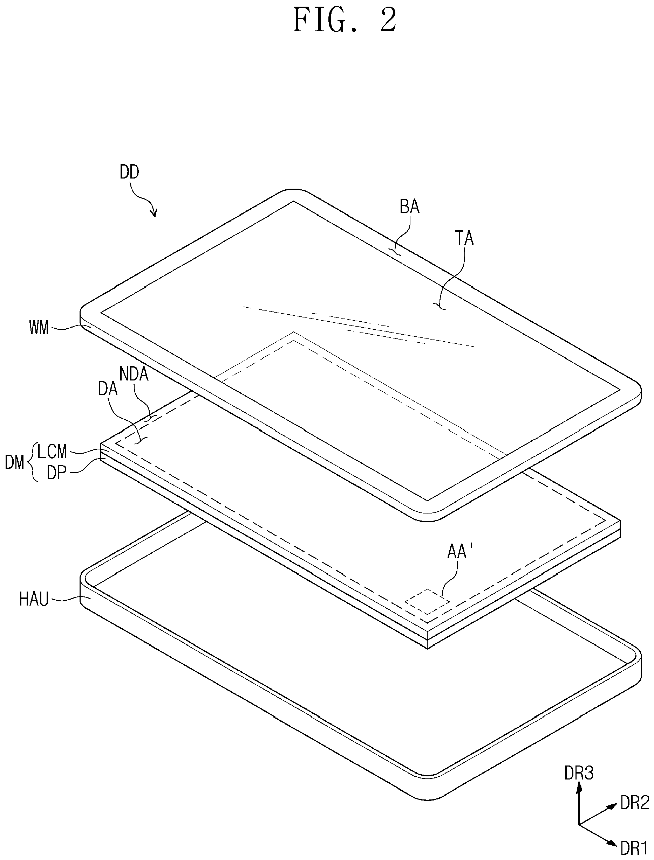

FIG. 1 is a perspective view of a display device according to an embodiment of the disclosure, and FIG. 2 is an exploded perspective view of a display device according to an embodiment of the disclosure.

Referring to FIGS. 1 and 2, a display device DD may be a device that is activated in response to an electrical signal and displays an image. The display device DD may be included in various types of electronic devices. For example, the display device DD may be included in large-sized devices such as a television and a billboard, as well as small and medium-sized devices such as a monitor, a mobile phone, a tablet computer, a navigation device, and a game console. Embodiments of the display device DD are illustrative, and the display device DD is not limited to any one as long as it does not deviate from the concept of the disclosure.

The display device DD may have a rectangular shape having long sides extending in a first direction DR1 and short sides extending in a second direction DR2 intersecting the first direction DR1 in a plan view. However, the disclosure is not limited thereto, and the display device DD may have various shapes such as a circular shape and a polygonal shape.

The display device DD may display an image IM in a third direction DR3 via a display surface IS parallel to a plane defined by the first direction DR1 and the second direction DR2. The third direction DR3 may be parallel to a normal direction of the display surface IS. The display surface IS on which the image IM is displayed may correspond to a front surface of the display device DD. The image IM may include a still image as well as a dynamic image. FIG. 1 illustrates icon images as an example of the image IM.

Herein, "on a plane" or "in a plan view may be defined as a state viewed in the third direction DR3. Herein, "on a cross-section" or "in a cross-sectional view" may be defined as a state viewed in the first direction DR1 or the second direction DR2. Directions indicated by the first to third directions DR1, DR2, and DR3 are a relative concept and may be converted to other directions.

FIG. 1 illustrates the display device DD having the planar display surface IS as an embodiment. However, the shape of the display surface IS of the display device DD is not limited thereto, and the display surface IS may have a curved shape or a three-dimensional shape.

The display device DD may be flexible. The term "flexible" is defined as having bendable properties, and may include everything from a completely foldable structure to a structure that is bendable at a level of several nanometers. For example, the flexible display device DD may include a curved display device or a foldable display device. However, the disclosure is not limited thereto, and the display device DD may be rigid.

The display surface IS of the display device DD may include a display portion D-DA and a non-display portion D-NDA. The display portion D-DA may display the image IM. A user may view the image IM via the display portion D-DA. In FIG. 1, the display portion D-DA is illustrated as having a rectangular shape in a plan view, but the disclosure is not limited thereto, and the display portion D-DA may have various shapes.

The non-display portion D-NDA may not display the image IM. The non-display portion D-NDA may correspond to a portion having a color (predetermined or selectable) and blocking light. The non-display portion D-NDA may be adjacent to the display portion D-DA. For example, the non-display portion D-NDA may extend outwardly from the display portion D-DA and surround the display portion D-DA in a plan view. However, the disclosure is not limited thereto, and the non-display portion D-NDA may be adjacent to only a side of the display portion D-DA or may be disposed on a side surface other than the front surface of the display device DD. However, the disclosure is not limited thereto, and the non-display portion D-NDA may be omitted.

In an embodiment, the display device DD may sense an external input applied from the outside. The external input may have various forms such as a pressure, a temperature, and light provided from the outside. The external input may include an input applied in close proximity to the display device DD (e.g., hovering) as well as an input of contacting the display device DD (e.g., a contact by a user's hand or a pen).

The display device DD may include a window WM, a display module DM, and an external casing HAU. The display module DM may include a display panel DP and a light control member LCM.

The window WM may be disposed on the display module DM. The window WM may protect the display module DM from an external impact. A front surface of the window WM may correspond to the above-described display surface IS of the display device DD. The front surface of the window WM may include a transmissive area TA and a bezel area BA.

The transmissive area TA of the window WM may be an optically transparent area. The window WM may transmit the image IM provided by the display module DM via the transmissive area TA, and the user may view the corresponding image IM. The transmissive area TA may correspond to the display portion D-DA of the display device DD.

The window WM may contain an optically transparent insulating material. For example, the window WM may contain glass, sapphire, or plastic. The window WM may have a single-layer or multi-layer structure. The window WM may further include functional layers such as an anti-fingerprint layer, a phase control layer, and a hard coating layer disposed on an optically transparent substrate.

The bezel area BA of the window WM may be provided as an area where a material having a color (predetermined or selectable) is deposited, coated, or printed. The bezel area BA of the window WM may prevent a component of the display module DM disposed to overlap the bezel area BA in a plan view from being viewed from the outside. The bezel area BA may correspond to the non-display portion D-NDA of the display device DD.

The display module DM may be disposed between the window WM and the external casing HAU. The display module DM may display an image IM in response to the electrical signal. The display module DM may include a display area DA and a non-display area NDA adjacent to the display area DA.

The display area DA may be an area activated in response to the electrical signal. The display area DA may be an area where the image IM provided by the display module DM is projected. The display area DA of the display module DM may correspond to the above-described transmissive area TA. Herein, "an area/portion and another area/portion correspond to each other" means that the areas/portions "overlap each other", and the areas/portions are not limited to having the same area size and/or the same shape. The image IM displayed on the display area DA may be viewed from the outside via the transmissive area TA.

The non-display area NDA may be disposed adjacent to the display area DA. For example, the non-display area NDA may surround the display area DA in a plan view. However, the disclosure is not limited thereto, and the non-display area NDA may be defined in various shapes. The non-display area NDA may be an area where a driving circuit or driving wiring for driving the display area DA, various signal lines that provide electrical signals, and pads are disposed. The non-display area NDA of the display module DM may correspond to the aforementioned bezel area BA. Components of the display module DM disposed in the non-display area NDA may be prevented by the bezel area BA from being viewed from the outside.

The display panel DP according to one embodiment may be a light emitting display panel, but the disclosure is not particularly limited thereto. For example, the display panel DP may be an organic light emitting display panel, an inorganic light emitting display panel, or a quantum dot light emitting display panel. A light emitting layer of the organic light emitting display panel may contain an organic light emitting material, and a light emitting layer of the inorganic light emitting display panel may contain an inorganic light emitting material. For example, the light emitting layer of the inorganic light emitting display panel may include a micro LED, a nano LED, or the like. A light emitting layer of the quantum dot light emitting display panel may include a quantum dot, a quantum rod, or the like. Hereinafter, the display panel DP will be described as the organic light emitting display panel.

The light control member LCM may be disposed on the display panel DP. After being provided on the display panel DP, the light control member LCM may be coupled to the display panel DP via a bonding process using a sealing member. However, the disclosure is not limited thereto, and the light control member LCM may be disposed (e.g., directly disposed) on the display panel DP. Herein, formation by a continuous process without a separate adhesive layer or adhesive member being disposed may be expressed as "directly disposed". For example, the expression "the light control member LCM is directly disposed on the display panel DP" may indicate that, after the display panel DP is formed, the light control member LCM is formed on a base surface provided by the display panel DP via a continuous process.

The light control member LCM may include light control patterns that may convert optical properties of source light provided by the display panel DP. The light control member LCM may convert a wavelength or a color of the source light or transmit the source light through the light control member LCM. The light control member LCM may control a color purity or a color reproducibility of light emitted from the display device DD, and may prevent reflection of external light incident from the outside of the display device DD.

The external casing HAU may be disposed beneath the display module DM to accommodate the display module DM in the external casing HAU. The external casing HAU may absorb the impact from the outside and may prevent foreign substances/moisture from penetrating into the display module DM to protect the display module DM. The external casing HAU according to one embodiment may be provided in a form in which multiple accommodating members are coupled to each other.

In an embodiment, the display module DM may further include an input sensing unit. The input sensing unit may acquire coordinate information of the external input applied from the outside of the display device DD. The input sensing unit may be disposed between the display panel DP and the light control member LCM. For example, the input sensing unit may be disposed (e.g., directly disposed) on the display panel DP via a continuous process, but the disclosure is not limited thereto, and the input sensing unit may be manufactured separately and attached to the display panel DP via an adhesive layer.

The display device DD may further include an electronic module including various functional modules for operating the display module DM, a power supply module that supplies power required for the display device DD, a bracket coupled to the display module DM and/or the external casing HAU to divide an internal space of the display device DD.

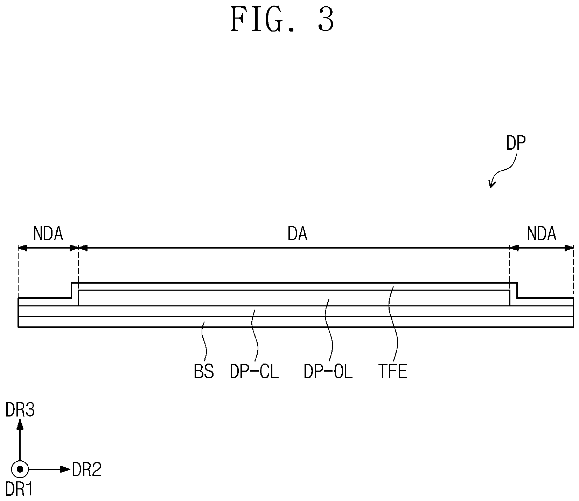

FIG. 3 is a schematic cross-sectional view of a display panel according to an embodiment of the disclosure.

Referring to FIG. 3, the display panel DP may include a base substrate BS, a circuit layer DP-CL, a display element layer DP-OL, and an encapsulation layer TFE.

The base substrate BS may include the display area DA and the non-display area NDA. The base substrate BS may provide the base surface on which the circuit layer DP-CL is disposed. The base substrate BS may be a rigid substrate, or a flexible substrate without being limited thereto.

The circuit layer DP-CL may be disposed on the base substrate BS. The circuit layer DP-CL may include driving elements, signal lines, and signal pads. The display element layer DP-OL may include light emitting elements disposed in the display area DA. The light emitting elements of the display element layer DP-OL may be electrically connected to the driving elements of the circuit layer DP-CL, and may provide the source light via the display area DA in response to a signal of the driving element.

The encapsulation layer TFE may be disposed on the display element layer DP-OL to seal the display element layer DP-OL. The encapsulation layer TFE may include multiple thin films. The thin films of the encapsulation layer TFE may improve optical efficiency or protect the light emitting elements.

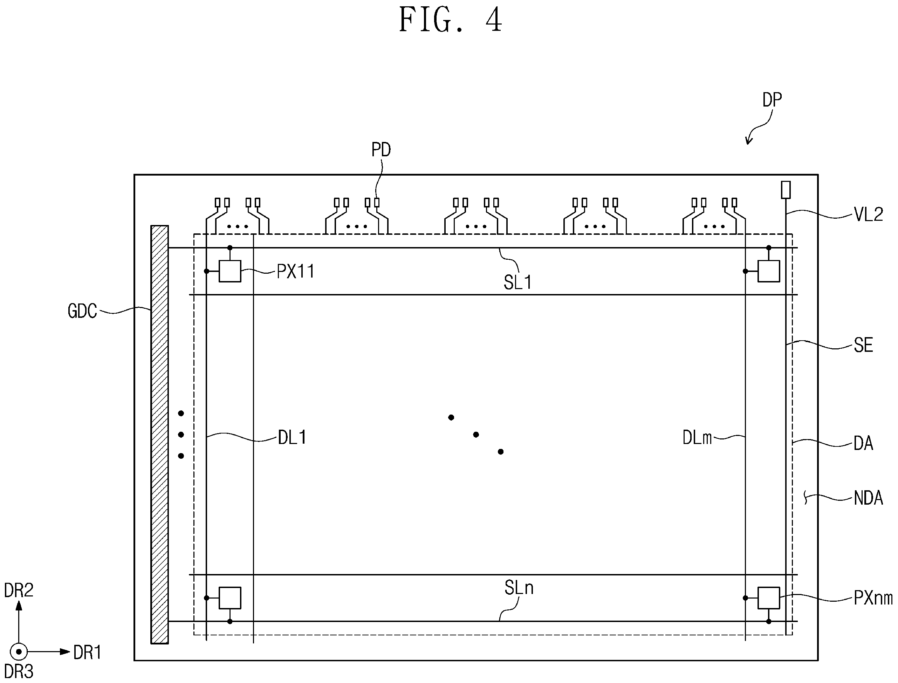

FIG. 4 is a plan view of a display panel according to an embodiment of the disclosure.

Referring to FIG. 4, the display panel DP may include pixels PX11 to PXnm disposed in the display area DA and signal lines SL1 to SLn and DL1 to DLm electrically connected to the pixels PX11 to PXnm. The display panel DP may include a driving circuit GDC and pads PD disposed in the non-display area NDA.

Each of the pixels PX11 to PXnm may include a light emitting element, multiple transistors (e.g., a switching transistor, a driving transistor, and the like) connected to the light emitting element, and a capacitor, which will be described below. Each of the pixels PX11 to PXnm may emit light in response to an electrical signal applied thereto. Although FIG. 4 illustrates the pixels PX11 to PXnm arranged in a matrix form as an embodiment, the arrangement of the pixels PX11 to PXnm is not limited thereto.

The signal lines SL1 to SLn and DL1 to DLm may include the scan lines SL1 to SLn and the data lines DL1 to DLm. Each of the pixels PX11 to PXnm may be connected to a corresponding scan line among the scan lines SL1 to SLn and a corresponding data line among the data lines DL1 to DLm. Depending on a configuration of a pixel circuit of the pixels PX11 to PXnm, more types of signal lines may be disposed in the display panel DP.

The driving circuit GDC may include a gate driving circuit. The gate driving circuit may generate gate signals and sequentially output the gate signals to the scan lines SL1 to SLn. The gate driving circuit may further output another control signal to the pixel circuit of the pixels PX11 to PXnm.

The driving circuit GDC and the pixels PX11 to PXnm according to one embodiment may include multiple thin film transistors formed via a low temperature polycrystalline silicon (LTPS) process or a low temperature polycrystalline oxide (LTPO) process.

The pads PD may be arranged in a direction in the non-display area NDA. The pads PD may be a portion connected to a circuit board. Each of the pads PD may be connected to the corresponding signal lines among the signal lines SL1 to SLn and DL1 to DLm, and may be connected to a corresponding pixel via the signal lines. The pads PD and the signal lines SL1 to SLn and DL1 to DLm may be integral with each other. However, the disclosure is not limited thereto, and the pads PD and the signal lines SL1 to SLn and DL1 to DLm may be disposed on different layers and connected to each other via a contact hole.

Although not shown, the power supply module may apply a driving voltage to the pixels PX11 to PXnm. For example, the driving voltage may be applied from the power supply module to a second power line VL2, and the second power line VL2 may apply the driving voltage to an auxiliary electrode SE. Details thereof will be described below.

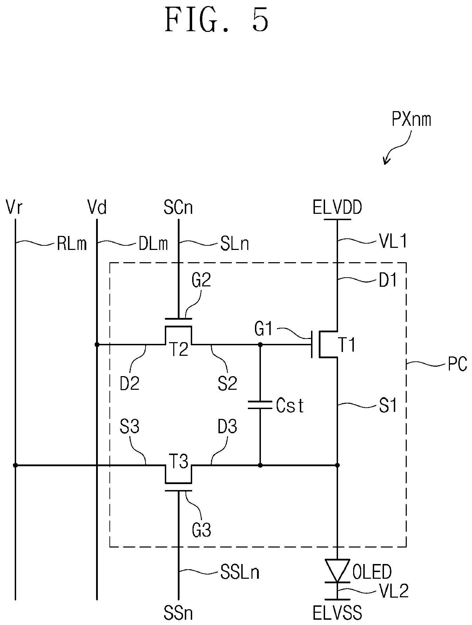

FIG. 5 is a schematic diagram of an equivalent circuit of a pixel according to an embodiment of the disclosure.

FIG. 5 schematically illustrates the pixel PXnm connected to the n-th scan line SLn, an n-th sensing line SSLn, the m-th data line DLm, and an m-th reference line RLm as an embodiment.

Referring to FIG. 5, the pixel PXnm may include a pixel circuit PC and a light emitting element OLED connected to the pixel circuit PC.

The pixel circuit PC may include multiple transistors T1, T2, and T3 and a capacitor Cst. The transistors T1, T2, and T3 may include a first transistor (or the driving transistor) T1, a second transistor (or the switch transistor) T2, and the third transistor (the sensing transistor) T3. Each of the first to third transistors T1, T2, and T3 may be a thin film transistor.

The first to third transistors T1, T2, and T3 may be NMOS transistors, but the disclosure is not limited thereto, and at least one of the first to third transistors T1, T2, and T3 may be a PMOS transistor. The first to third transistors T1, T2, and T3 may include sources S1, S2, and S3, drains D1, D2, and D3, and gates G1, G2, and G3, respectively.

The light emitting element OLED may be an organic light emitting element including an anode (or a first electrode) and a cathode (or a second electrode). The anode of the light emitting element OLED may receive a first voltage (or a first driving voltage) ELVDD via the driving transistor T1, and the cathode of the light emitting element OLED may receive a second voltage (or a second driving voltage) ELVSS. For example, the driving transistor T1 may receive the first voltage ELVDD from the power supply module via a first power supply line VL1, and the anode may receive the first voltage ELVDD via the driving transistor T1. For example, the cathode may receive the second voltage ELVSS via the second power supply line VL2 from the power supply module. The light emitting element OLED may emit light by receiving the first voltage ELVDD and the second voltage ELVSS.

The driving transistor T1 may include a drain D1 that receives the first voltage ELVDD, a source S1 connected to the anode of the light emitting element OLED, and a gate G1 connected to the capacitor Cst. The driving transistor T1 may control a driving current flowing from the first power line VL1 to the light emitting element OLED in response to a voltage value stored in the capacitor Cst.

The switch transistor T2 may include a drain D2 connected to the m-th data line DLm, a source S2 connected to the capacitor Cst, and a gate G2 that receives an n-th write scan signal SCn. The m-th data line DLm may receive a data voltage Vd and a data voltage for sensing. The switch transistor T2 may transfer the data voltage Vd input from the m-th data line DLm to the driving transistor T1 in response to a switching voltage input from the n-th scan line SLn.

The sensing transistor T3 may include a source S3 connected to the m-th reference line RLm, a drain D3 connected to the anode of the light emitting element OLED, and a gate G3 that receives an n-th sampling scan signal SSn. The m-th reference line RLm may receive a reference voltage Vr.

The capacitor Cst may be connected to the gate G1 of the driving transistor T1 and the anode of the light emitting element OLED. The capacitor Cst may include a first capacitor electrode connected to the gate G1 of the driving transistor T1 and a second capacitor electrode connected to the anode of the light emitting element OLED. The capacitor Cst may store a voltage corresponding to a difference between a voltage received from the switch transistor T2 and the first voltage ELVDD.

The equivalent circuit of pixel PXnm is not limited to the embodiment shown in FIG. 5. In another embodiment of the disclosure, the equivalent circuit diagram of the pixel PXnm may be implemented in various forms to allow the light emitting element OLED to emit light.

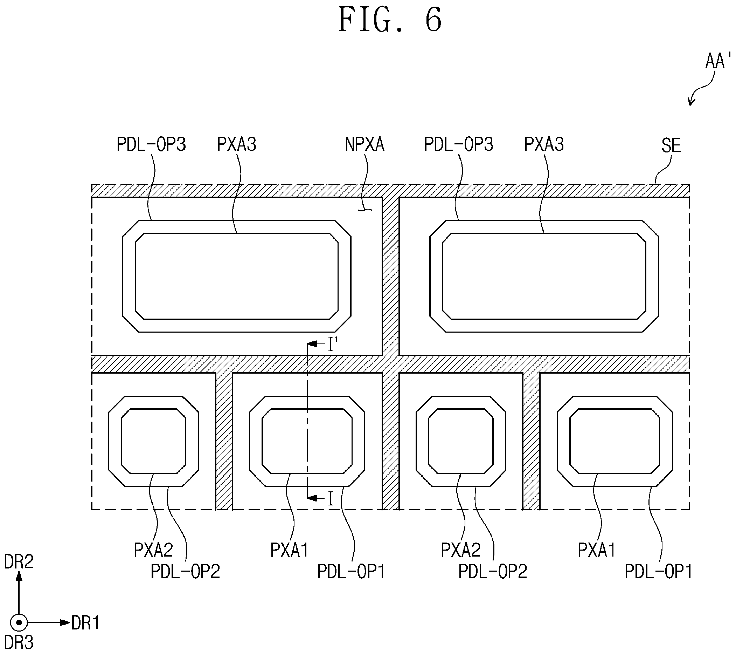

FIG. 6 is an enlarged view of area AA' shown in FIG. 2.

Referring to FIG. 6, light emitting areas PXA1, PXA2, and PXA3 corresponding to the light emitting elements disposed in the display area DA, and a non-light emitting area NPXA adjacent to the light emitting areas PXA1, PXA2, and PXA3 may be defined in the display panel DP (see FIG. 2).

The light emitting areas PXA1, PXA2, and PXA3 may correspond to areas from which light provided from the light emitting elements is emitted. The light emitting areas PXA1, PXA2, and PXA3 may include a first light emitting area PXA1, a second light emitting area PXA2, and a third light emitting area PXA3. The first to third light emitting areas PXA1, PXA2, and PXA3 may be distinguished from each other based on colors of light emitted toward the outside of the display device DD (see FIG. 1).

The first light emitting area PXA1 may correspond to an area that provides first color light, the second light emitting area PXA2 may correspond to an area that provides second color light, and the third light emitting area PXA3 may correspond to an area that provides third color light. In one embodiment, first to third color light may have different colors. For example, the first color light may be red light, the second color light may be green light, and the third color light may be blue light. However, the disclosure is not limited thereto.

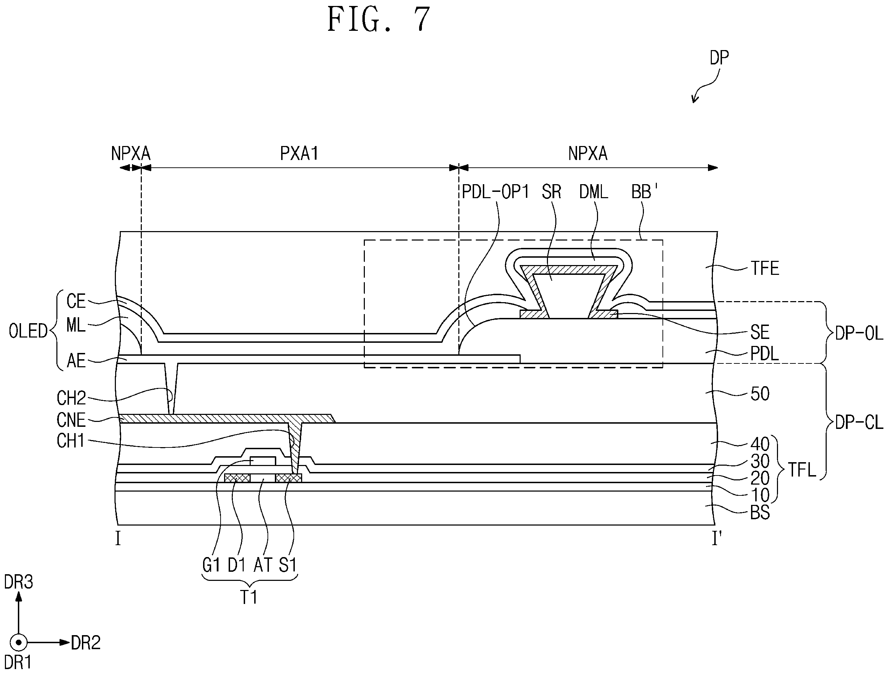

The first light emitting area PXA1 may be defined by a first opening PDL-OP1 defined in a pixel defining layer PDL (see FIG. 7). The first light emitting area PXA1 may be spaced apart from each of the second light emitting area PXA2 and the third light emitting area PXA3. The first light emitting area PXA1 may include multiple first light emitting areas. The first light emitting areas PXA1 may be spaced apart from each other in the first direction DR1 with the second light emitting area PXA2 interposed between the first light emitting areas PXA1 and spaced apart from each other in the second direction DR2 with the third light emitting area PXA3 interposed between the first light emitting areas PXA1.

The second light emitting area PXA2 may be defined by a second opening PDL-OP2 defined in the pixel defining layer PDL. The second light emitting area PXA2 may be disposed to be spaced apart from each of the first light emitting area PXA1 and the third light emitting area PXA3. The second light emitting area PXA2 may include multiple second light emitting areas. The second light emitting areas PXA2 may be spaced apart from each other in the first direction DR1 with the first light emitting area PXA1 interposed between the second light emitting areas PXA2 and spaced apart from each other in the second direction DR2 with the third light emitting area PXA3 interposed between the second light emitting areas PXA2.

The third light emitting area PXA3 may be defined by a third opening PDL-OP3 defined in the pixel defining layer PDL. The third light emitting area PXA3 may be disposed to be spaced apart from each of the first light emitting area PXA1 and the second light emitting area PXA2. The third light emitting area PXA3 may include multiple third light emitting areas. The third light emitting area PXA3 may be arranged in the first direction DR1, and may be arranged in the second direction DR2 with the first light emitting area PXA1 and the second light emitting area PXA2 interposed between the third light emitting area PXA3.

However, the arrangement of the first to third light emitting areas PXA1, PXA2, and PXA3 is not limited to the embodiment shown in FIG. 6, and the arrangement of the light emitting areas may vary depending on a design of the display device DD.

Each of the first to third light emitting areas PXA1, PXA2, and PXA3 may have a polygonal shape in a plan view. For example, each of the first light emitting area PXA1, the second light emitting area PXA2, and the third light emitting area PXA3 may have an octagonal shape in a plan view. Areas of the first light emitting area PXA1, the second light emitting area PXA2, and the third light emitting area PXA3 may be different from each other. For example, the area of the first light emitting area PXA1 may be greater than the area of the second light emitting area PXA2, and the area of the third light emitting area PXA3 may be greater than the area of the first light emitting area PXA1 in a plan view.

The shapes and the areas of the first to third light emitting areas PXA1, PXA2, and PXA3 may be designed in various ways in consideration of emission efficiency of color light emitted via the areas, and are not limited to the embodiment shown in FIG. 6. For example, each of the first to third light emitting areas PXA1, PXA2, and PXA3 may have a rectangular shape or a circular shape in a plan view. For example, some of the first to third light emitting areas PXA1, PXA2, and PXA3 may have a rhombic shape, and the others may have the octagonal shape in a plan view, but the disclosure is not limited thereto.

The non-light emitting area NPXA, as an area that does not overlap the light emitting areas PXA1, PXA2, and PXA3 in a plan view, may be disposed adjacent to the light emitting areas PXA1, PXA2, and PXA3. The non-light emitting area NPXA may set boundaries of the light emitting areas PXA1, PXA2, and PXA3, and may prevent color mixing between the light emitting areas PXA1, PXA2, and PXA3.

The auxiliary electrode SE may be disposed in the non-light emitting area NPXA. The auxiliary electrode SE may extend in the first direction DR1 or the second direction DR2. In a plan view, the auxiliary electrode SE may not overlap the light emitting areas PXA1, PXA2, and PXA3. For example, the auxiliary electrode SE may be disposed in an area in which the first to third light emitting areas PXA1, PXA2, and PXA3 are spaced apart from each other. In a plan view, the auxiliary electrode SE may not overlap each of the first opening PDL-OP1, the second opening PDL-OP2, and the third opening PDL-OP3. The auxiliary electrode SE shown in FIG. 6 is schematically illustrated for convenience of description, and an arrangement, a shape, an area, and the like of the auxiliary electrode SE may vary depending on a design of the display panel DP.

FIG. 7 is a schematic cross-sectional view of a display panel taken along line I-I' in FIG. 6.

Referring to FIG. 7, the display panel DP may include the base substrate BS, the circuit layer DP-CL, the display element layer DP-OL, and the encapsulation layer TFE.

The display panel DP may include insulating layers, a semiconductor pattern, a conductive pattern, signal lines, and the like. In a manufacturing stage of the display panel DP, the insulating layer, a semiconductor layer, and a conductive layer may be formed on the base substrate BS by coating, deposition, or the like. Thereafter, the insulating layer, the semiconductor layer, and the conductive layer may be selectively patterned by a photolithography process. With such process, the semiconductor pattern, the conductive pattern, the signal lines, and the like included in the circuit layer DP-CL may be formed. The semiconductor pattern of the circuit layer DP-CL may be arranged in a pattern across the pixels.

The base substrate BS may include a glass substrate, a metal substrate, a polymer substrate, or an organic/inorganic composite material substrate. The base substrate BS may have a single-layer or multi-layer structure. For example, the base substrate BS of the multi-layer structure may include synthetic resin layers and at least one inorganic layer disposed between the synthetic resin layers.

The synthetic resin layer may include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, a perylene-based resin, and a polyimide-based resin. However, the material of the synthetic resin layer of the base substrate BS is not limited thereto.

The at least one inorganic layer may be disposed on a top surface of the base substrate BS. The inorganic layer may constitute a barrier layer and/or a buffer layer. FIG. 7 shows the inorganic layer defined as a buffer layer 10 as an embodiment. The buffer layer 10 may improve a bonding strength between the base substrate BS and the semiconductor pattern of the circuit layer DP-CL. The buffer layer 10 may contain at least one of aluminum oxide, titanium oxide, silicon oxide, silicon nitride, silicon oxynitride, zirconium oxide, and hafnium oxide, but the disclosure is not limited thereto.

The circuit layer DP-CL may include the semiconductor pattern. The semiconductor pattern may contain polysilicon. However, the disclosure is not limited thereto, and the semiconductor pattern may contain amorphous silicon or a metal oxide. The circuit layer DP-CL may include the transistors constituting the pixel circuit PC (see FIG. 5) and the insulating layers. In FIG. 7, the first transistor T1 and first to fourth insulating layers 20, 30, 40, and 50 are illustrated as an embodiment. The source S1, an active area AT, and the drain D1 of the first transistor T1 may be formed from the semiconductor pattern.

The semiconductor pattern may have different electrical properties depending on whether it is doped. The semiconductor pattern may include a first area having high conductivity and a second area having low conductivity. The first area may be doped with an N-type dopant or a P-type dopant. A P-type transistor may include a doped area doped with a P-type dopant, and an N-type transistor may include a doped area doped with an N-type dopant. The second area may be a non-doped area or an area doped at a lower concentration than the first area.

The conductivity of the first area may be greater than the conductivity of the second area, and the first area may substantially serve as an electrode or a signal line. The second area may substantially correspond to an active area (or a channel area) of the transistor. In other words, a portion of the semiconductor pattern may be the active area of the transistor, and another portion may be a source or a drain of the transistor.

The first to fourth insulating layers 20, 30, 40, and 50 may be disposed on the buffer layer 10. The first to fourth insulating layers 20, 30, 40, and 50 may include an inorganic layer or an organic layer and may have a single-layer structure or a multi-layer structure.

The inorganic layer may contain at least one of aluminum oxide, titanium oxide, silicon oxide, silicon nitride, silicon oxynitride, zirconium oxide, and hafnium oxide, but the disclosure is not limited thereto. The organic layer may contain at least one of a phenol-based polymer, an acryl-based polymer, an imide-based polymer, an aryl ether-based polymer, an amide-based polymer, a fluorine-based polymer, a p-xylene-based polymer, a vinyl alcohol-based polymer, and a combination thereof, but the disclosure is not limited thereto.

The first insulating layer 20 may cover the semiconductor pattern of the circuit layer DP-CL. The gate G1 of the first transistor T1 may be disposed on the first insulating layer 20. The gate G1 may be a portion of the conductive pattern. The gate G1 may overlap the active area AT in a plan view. The gate G1 may function as a mask in a process of doping the semiconductor pattern. The second insulating layer 30 may be disposed on the first insulating layer 20 and may cover the gate G1. The third insulating layer 40 may be disposed on the second insulating layer 30.

In an embodiment, a layer including the buffer layer 10, the first to third insulating layers 20, 30, and 40, and a transistor (e.g., the first transistor T1 in FIG. 5) formed between the first to third insulating layers 20, 30, and 40 may be defined as a transistor layer TFL.

A connection electrode CNE may be disposed between the first transistor T1 and the light emitting element OLED and connect the first transistor T1 and the light emitting element OLED to each other. The connection electrode CNE may be disposed on the third insulating layer 40 and connected to the source S1 via a first contact hole CH1 extending through the first, second, and third insulating layers 20, 30, and 40.

The fourth insulating layer 50 may be disposed on the third insulating layer 40. The fourth insulating layer 50 may cover the connection electrode CNE. In one embodiment, the fourth insulating layer 50 may include an organic layer. The fourth insulating layer 50 including the organic layer may provide a flat top surface. However, the disclosure is not necessarily limited thereto.

The display element layer DP-OL may be disposed on the circuit layer DP-CL. The display element layer DP-OL may include the light emitting element OLED, the pixel defining layer PDL, the separator SR, the auxiliary electrode SE, and the dummy layer DML. The light emitting element OLED may include a first electrode (or an anode) AE, an intermediate layer ML, and a second electrode (a cathode) CE.

The first electrode AE may be disposed on the fourth insulating layer 50 of the circuit layer DP-CL. The first electrode AE may be connected to the connection electrode CNE via a second contact hole CH2 extending through the fourth insulating layer 50. The first electrode AE may be connected to the first transistor T1 via the connection electrode CNE. The first electrode AE may include multiple layers. The first electrode AE may receive the first voltage ELVDD (see FIG. 5) via the first transistor T1.

The pixel defining layer PDL may be disposed on the fourth insulating layer 50. In the pixel defining layer PDL, the first opening PDL-OP1 that exposes a portion of the first electrode AE may be defined. The pixel defining layer PDL may cover a portion of a top surface of the first electrode AE. The portion of the first electrode AE exposed by the first opening PDL-OP1 of the pixel defining layer PDL may correspond to the first light emitting area PXA1.

The pixel defining layer PDL may contain an organic material. For example, the pixel defining layer PDL may contain a polyacrylate-based resin or a polyimide-based resin, but the material of the pixel defining layer PDL is not limited thereto. In another embodiment, the pixel defining layer PDL may be made of an inorganic material. For example, the pixel defining layer PDL may contain at least one of silicon nitride (SiNₓ), silicon oxide (SiOₓ), silicon nitride oxide (SiOₓN_{y}), and the like, but the material of the pixel defining layer PDL is not limited thereto.

The pixel defining layer PDL may contain a light absorbing material or may have a color (predetermined or selectable). For example, the pixel defining layer PDL may contain a base resin and a black pigment and/or a black dye mixed with the base resin.

The intermediate layer ML may overlap the first opening PDL-OP1 in a plan view. The intermediate layer ML may include multiple organic layers, a charge generating layer, and the like disposed between the first electrode AE and the second electrode CE facing each other. The organic layers may have a sequentially stacked structure. Each of the organic layers may include functional layers containing a hole transport material and an electron transport material, and a light emitting material. In one embodiment, the light emitting element OLED may be a light emitting element of a tandem structure including multiple light emitting layers.

The second electrode CE may face the first electrode AE and may be disposed on the intermediate layer ML. The second electrode CE may be provided as a common layer that overlaps a light emitting area PXA and the non-light emitting area NPXA in a plan view. A common voltage may be provided to the second electrode CE. For example, the common voltage may be the second voltage ELVSS (see FIG. 5).

The first electrode AE may be a transflective electrode or a reflective electrode. The first electrode AE may contain silver (Ag) or a compound or a mixture (e.g., AgMg, AgYb, or MgAg) containing the same. However, the disclosure is not limited thereto, and the first electrode AE according to one embodiment of the disclosure may contain Mg, Cu, Al, Pt, Pd, Au, Ni, Nd, Ir, Cr, Li, Ca, LiF/Ca, LiF/Al, Mo, Ti, Yb, W, In, Zn, Sn, or a compound or a mixture containing the same.

The disclosure is not limited thereto, and the first electrode AE may have a structure of multiple layers including a reflective film or a semi-permeable film made of the above materials, and a transparent conductive film made of indium tin oxide (ITO), indium zinc oxide (IZO), zinc oxide (ZnO), indium tin zinc oxide (ITZO), or the like.

The second electrode CE may be formed by being thinly deposited to have light transmitting properties. For example, the second electrode CE may have a thickness equal to or less than about 100 Å. However, the thickness of the second electrode CE is not limited thereto.

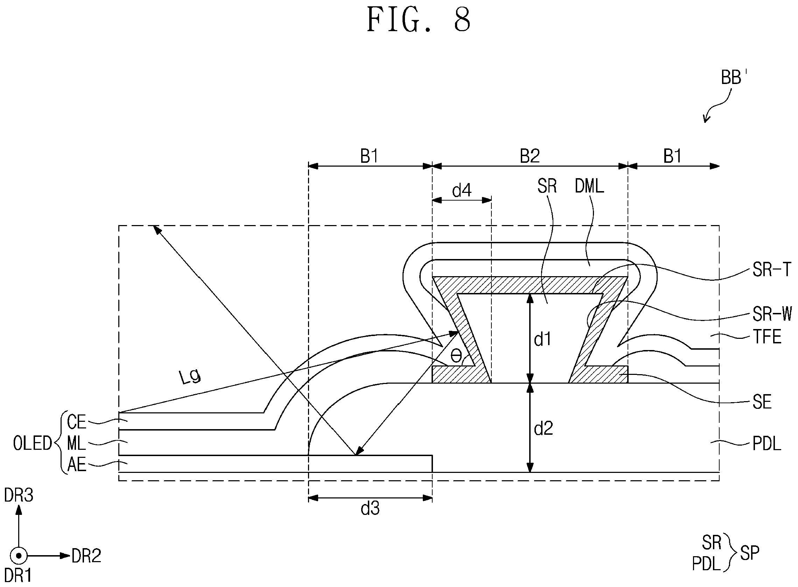

The separator SR may be disposed on the pixel defining layer PDL. In one embodiment, the second electrode CE and the intermediate layer ML may be formed via common deposition on the pixels using an open mask. In this regard, the intermediate layer ML may be divided by the separator SR. The separator SR may have a closed line shape with respect to the first light emitting area PXA1. As shown in FIG. 7, the separator SR may have a reversed tapered shape in a cross-sectional view. The shape of the separator SR will be described in detail with reference to FIG. 8.

In one embodiment of the disclosure, the separator SR may contain an insulating material, for example, an organic insulating material. The separator SR may contain an inorganic insulating material, may include multiple layers made of the organic insulating material and the inorganic insulating material, and may contain a conductive material according to an embodiment. For example, as long as the intermediate layer ML is electrically disconnected for each pixel, the type of material for the separator SR is not particularly limited.

The auxiliary electrode SE may be disposed on the separator SR. As shown, the auxiliary electrode SE may cover a top surface and side surfaces of the separator SR. The auxiliary electrode SE may extend to the pixel defining layer PDL along the top surface and the side surfaces of the separator SR. For example, the auxiliary electrode SE may be disposed on the separator SR and the pixel defining layer PDL. The auxiliary electrode SE may overlap the pixel defining layer PDL in a plan view. The auxiliary electrode SE may be disposed in the non-light emitting area NPXA.

According to one embodiment of the disclosure, the auxiliary electrode SE contains a reflective material. The auxiliary electrode SE may contain a reflective metal material. For example, the auxiliary electrode SE may contain copper (Cu). However, the disclosure is not limited thereto, and the auxiliary electrode SE may contain Mg, Cu, Al, Pt, Pd, Au, Ni, Nd, Ir, Cr, Li, Ca, LiF/Ca, LiF/Al, Mo, Ti, Yb, W, In, Zn, Sn, or a compound or a mixture containing the same.

A dummy layer DML may be disposed on the auxiliary electrode SE. The dummy layer DML and the intermediate layer ML may be formed via a same process. Accordingly, the dummy layer DML and the intermediate layer ML may contain a same material. The dummy layer DML may be formed in contact with a top surface and portions of side surfaces of the auxiliary electrode SE. The intermediate layer ML may be formed in contact with a portion of the auxiliary electrode SE disposed on the pixel defining layer PDL, and the second electrode CE may be disposed in an area in which the intermediate layer ML and the dummy layer DML are not in contact with the auxiliary electrode SE.

The auxiliary electrode SE may be electrically connected to the second electrode CE. For example, the intermediate layer ML may be disconnected by the separator SR, and the second electrode CE and the auxiliary electrode SE may be in contact with and be electrically connected to each other in an area where the intermediate layer ML is disconnected. The auxiliary electrode SE may contain one of the materials that can be used for the second electrode CE. The second electrode CE may be readily in contact with the auxiliary electrode SE containing the same material. Accordingly, the second electrode CE may be electrically connected to the auxiliary electrode SE.

In the case that the display device DD (see FIG. 1) has a large area, a resistance of the second electrode CE may increase, resulting in a voltage drop (IR drop), which may prevent uniform image quality from being realized. However, according to the disclosure, the auxiliary electrode SE electrically connected to a power supply line to which the second voltage ELVSS (see FIG. 5) is provided may be electrically connected to the second electrode CE. Accordingly, the second voltage ELVSS may be directly provided to the second electrode CE electrically connected to the auxiliary electrode SE. As the second electrode CE receives the second voltage ELVSS directly from the auxiliary electrode SE, the resistance of the second electrode CE may be reduced, and the second electrode CE electrically connected to the auxiliary electrode SE may prevent the voltage drop problem. As a result, the display device DD (see FIG. 1) having stable luminance of the image may be provided.

The encapsulation layer TFE may be disposed on the display element layer DP-OL to seal the display element layer DP-OL. The encapsulation layer TFE may include multiple inorganic films and at least one organic film.

Each of the inorganic films may protect the light emitting elements OLED from moisture and/or oxygen. Each of the inorganic films may contain at least one of aluminum oxide, titanium oxide, silicon oxide, silicon nitride, silicon oxynitride, zirconium oxide, and hafnium oxide, but the disclosure is not limited thereto.

The at least one organic film may protect the light emitting elements OLED from foreign substances such as dust particles. The at least one organic film may contain an acryl-based resin, but the disclosure is not limited thereto.

FIG. 8 is an enlarged view of area BB' shown in FIG. 7. FIG. 8 schematically illustrates that light Lg emitted from the intermediate layer ML is reflected from the auxiliary electrode SE and proceeds to the outside of the display device DD (see FIG. 1).

Referring to FIG. 8, the light Lg may be emitted from a light emitting layer included in the intermediate layer ML. The emitted light Lg may be reflected from a portion of the auxiliary electrode SE disposed on a side surface SR-W of the separator SR and incident to the first electrode AE, and the light Lg incident to the first electrode AE may be reflected from the first electrode AE and emitted to the outside of the display device DD.

The pixel defining layer PDL and the separator SR may function as a partition wall SP. For example, the partition wall SP may include the pixel defining layer PDL and the separator SR. The partition wall SP may include a first portion B 1 and a second portion B2. A thickness of the second portion B2 in the third direction DR3 may be greater than a thickness of the first portion B 1 in the third direction DR3. The first portion B 1 may be a portion including only the pixel defining layer PDL, and the second portion B2 may be a portion including the pixel defining layer PDL and the separator SR disposed on the pixel defining layer PDL. The light emitting area PXA (see FIG. 7) may be defined by the first portion B1 of the partition wall SP. The intermediate layer ML may be disconnected by the second portion B2 of the partition wall SP, and the second electrode CE and the auxiliary electrode SE may contact and be electrically connected with each other in the second portion B2.

According to one embodiment of the disclosure, a thickness d1 of the separator SR in the third direction DR3 and a thickness d2 of the pixel defining layer PDL in the third direction DR3 may be the same. For example, the thickness d1 of the separator SR may be in a range of about 1 µm to about 2 µm. The thickness d2 of the pixel defining layer PDL may be in a range of about 1 µm to about 2 µm. However, the disclosure is not limited thereto, and the thickness d2 of the pixel defining layer PDL may be greater than the thickness d1 of the separator SR.

According to one embodiment of the disclosure, a portion of the first electrode AE may overlap the pixel defining layer PDL in a plan view. The pixel defining layer PDL may be disposed on the first electrode AE in an area overlapping the portion of the first electrode AE. The first electrode AE, which overlaps the pixel defining layer PDL in a plan view, may not overlap the separator SR in a plan view. However, the disclosure is not limited thereto, and the first electrode AE may partially overlap the separator SR in a plan view. A length d3 of the portion where the first electrode AE overlaps the pixel defining layer PDL in a plan view in the second direction DR2 may be equal to or greater than about 3 µm.

According to one embodiment of the disclosure, the pixel defining layer PDL may contain a light-transmissive material. Accordingly, the light Lg reflected from the portion of the auxiliary electrode SE disposed on the side surface SR-W of the separator SR may be incident on the first electrode AE overlapping the pixel defining layer PDL in a plan view. The light Lg may be reflected from the first electrode AE overlapping the pixel defining layer PDL in a plan view, and the reflected light Lg may be emitted to the outside of the display device DD. As a result, the light Lg emitted from the light emitting layer included in the intermediate layer ML may be readily emitted to the outside of the display device DD, and the display device DD with increased light emission efficiency may be provided.

A length (or a width) of the separator SR in the second direction DR2 may gradually increase in the third direction DR3, for example, in a thickness direction of the separator SR. For example, the separator SR may have the reversed tapered shape in a cross-sectional view. An angle 'θ' (hereinafter, a taper angle) formed by the side surface SR-W of the separator SR facing the intermediate layer ML with respect to a top surface of the pixel defining layer PDL may be an acute angle. That is to say, the side surface SR-W of the separator SR facing the intermediate layer ML may be inclined toward the light emitting element OLED. The taper angle 'θ' may be in a range of about 70 ° to about 80 °. However, the disclosure is not limited thereto, and the taper angle 'θ' may be variously set as long as the separator SR is able to electrically disconnect the intermediate layer ML for each pixel. The separator SR may include multiple layers and an uppermost layer of the separator SR may include a tip protruding from a middle layer of the separator SR, but the disclosure is not limited thereto.

In the auxiliary electrode SE, a length d4 of a portion disposed on the pixel defining layer PDL and extending on the pixel defining layer PDL when viewed in the third direction DR3 and a length of a portion disposed on a top surface SR-T of the separator SR from a point corresponding to a distal end of a bottom surface of the separator SR to a distal end of the portion extended in an opposite direction to the second direction DR2 may be the same. For example, the length d4 of the portion of the auxiliary electrode SE extending on the pixel defining layer PDL may be equal to or less than about 0.5 µm.

In the display device DD according to one embodiment of the disclosure, as the auxiliary electrode SE containing the reflective material is disposed on the side surface SR-W of the separator SR, the light Lg emitted from the light emitting layer included in the intermediate layer ML to the auxiliary electrode SE may be reflected from the auxiliary electrode SE and emitted to the outside of the display device DD. As a result, the light emission efficiency may be improved by about 10 % compared to an amount of the light Lg emitted from the light emitting layer.

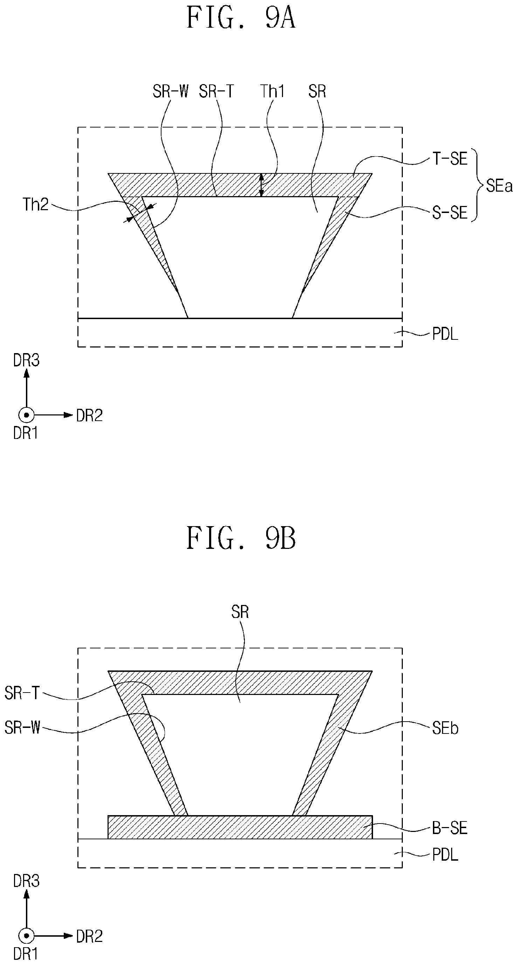

FIG. 9A is a schematic enlarged cross-sectional view of a separator and an auxiliary electrode according to an embodiment of the disclosure.

Referring to FIG. 9A, an auxiliary electrode SEa may include an upper auxiliary electrode T-SE disposed on the top surface SR-T of the separator SR and a side auxiliary electrode S-SE disposed on the side surface SR-W of the separator SR. The upper auxiliary electrode T-SE may be disposed to cover the top surface SR-T of the separator SR, and may have a uniform thickness Th1 across the top surface SR-T of the separator SR in a normal direction of the top surface SR-T of the separator SR. The side auxiliary electrode S-SE may be disposed to cover the side surface SR-W of the separator SR, and may have a thickness Th2 not uniform across the side surface SR-W of the separator SR in a normal direction of the side surface SR-W of the separator SR.

According to one embodiment of the disclosure, the thickness Th1 of the upper auxiliary electrode T-SE and the thickness Th2 of the side auxiliary electrode S-SE may be different from each other. For example, the thickness Th1 of the upper auxiliary electrode T-SE may be greater than the thickness Th2 of the side auxiliary electrode S-SE. During the auxiliary electrode SEa is formed, as the separator SR has the reversed tapered shape, the upper auxiliary electrode T-SE may be uniformly deposited in a forward direction. However, the side auxiliary electrode S-SE may not be uniformly deposited by the top surface SR-T of the separator SR as becoming closer to the pixel defining layer PDL. Therefore, the thickness Th2 of the side auxiliary electrode S-SE may be less than the thickness Th1 of the upper auxiliary electrode T-SE. As the pixel defining layer PDL becomes closer, it may become difficult for a deposition material to be deposited on the side surface SR-W of the separator SR by the top surface SR-T of the separator SR, so that the thickness Th2 of the side auxiliary electrode S-SE may become smaller.

FIG. 9B is a schematic enlarged cross-sectional view of a separator, an auxiliary electrode, and a lower auxiliary electrode according to an embodiment of the disclosure.

Referring to FIG. 9B, an auxiliary electrode SEb may be disposed on the top surface SR-T and the side surfaces SR-W of the separator SR to cover an entirety of the top surface SR-T and the side surfaces SR-W of the separator SR.

A lower auxiliary electrode B-SE may be disposed between the separator SR and the pixel defining layer PDL. The lower auxiliary electrode B-SE may directly be in contact with each of the bottom surface of the separator SR and the auxiliary electrode SEb. According to one embodiment of the disclosure, the auxiliary electrode SEb and the lower auxiliary electrode B-SE may contain a same material. For example, each of the auxiliary electrode SEb and the lower auxiliary electrode B-SE may contain a reflective material. However, the disclosure is not limited thereto, and the lower auxiliary electrode B-SE may not contain a reflective material. For example, the lower auxiliary electrode B-SE may contain a metal material that may be electrically connected to the auxiliary electrode SEb. Accordingly, the lower auxiliary electrode B-SE and the auxiliary electrode SEb may be electrically connected to each other.

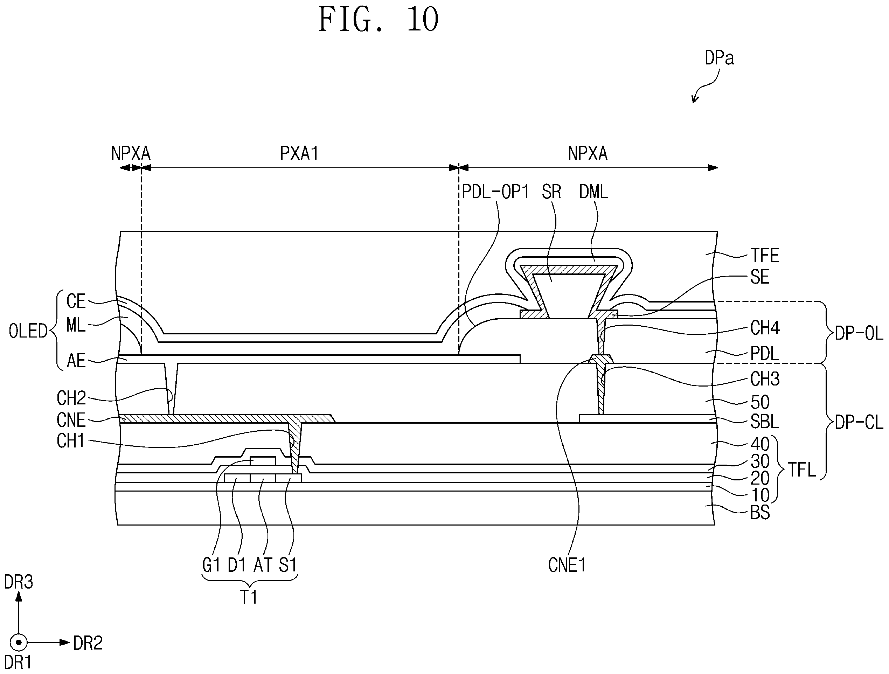

FIG. 10 is a schematic cross-sectional view showing a portion of a display panel according to an embodiment of the disclosure. Redundant descriptions will be omitted below.

Referring to FIG. 10, a display panel DPa may further include an auxiliary wire SBL disposed on the third insulating layer 40. In one embodiment, the auxiliary wire SBL and the connection electrode CNE may be disposed on a same layer. The auxiliary wire SBL may be electrically connected to the power supply line to which the second voltage ELVSS (see FIG. 5) is provided to provide the second voltage ELVSS.

The auxiliary wire SBL may be electrically connected to the auxiliary electrode SE disposed on the pixel defining layer PDL. For example, a first connection electrode CNE1 may be disposed on the fourth insulating layer 50 to electrically connect the auxiliary wire SBL and the auxiliary electrode SE to each other. The auxiliary electrode SE may be connected to the first connection electrode CNE1 via a fourth contact hole CH4 extending through the pixel defining layer PDL, and the first connection electrode CNE1 may be connected to the auxiliary wire SBL via a third contact hole CH3 extending through the fourth insulating layer 50. The second voltage ELVSS (see FIG. 5) may be applied to the auxiliary electrode SE via the auxiliary wire SBL. However, the disclosure is not limited thereto, and the auxiliary wire SBL and the gate G1 or the source S1 and the drain D1 may be disposed on a same layer.

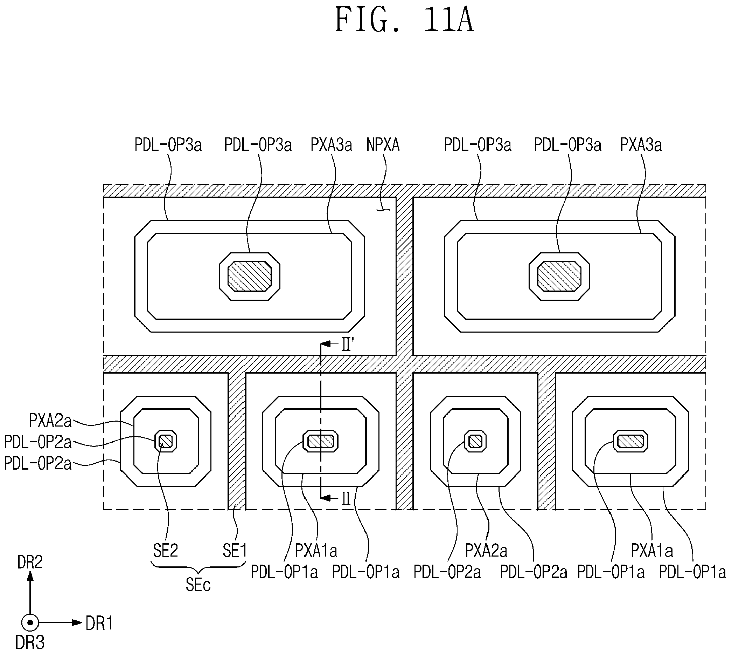

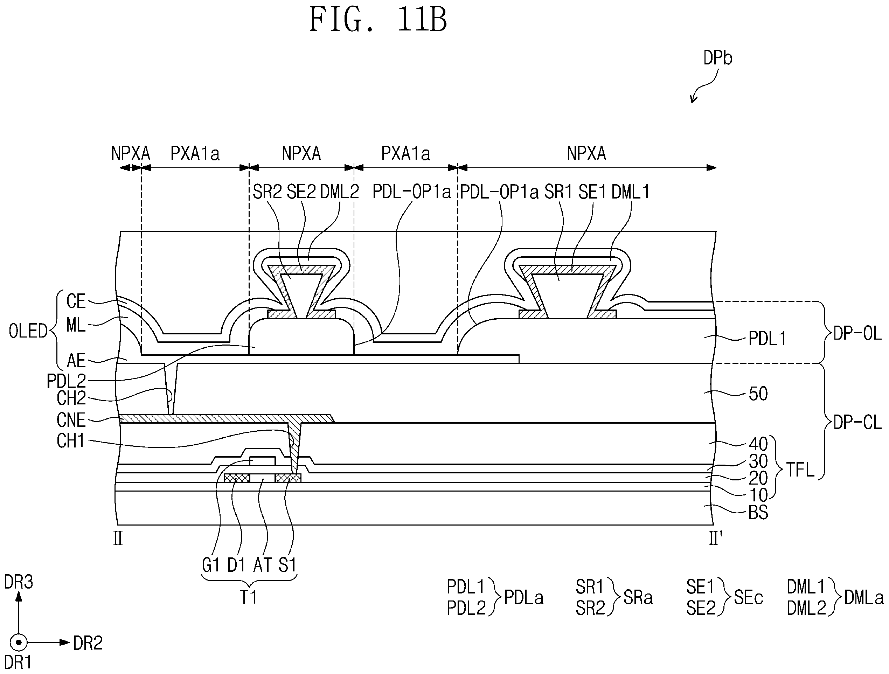

FIG. 11A is an enlarged plan view of a portion of a display panel according to an embodiment of the disclosure. FIG. 11B is a schematic cross-sectional view of a display panel taken along line II-II' in FIG. 11A.

Referring to FIGS. 11A and 11B, light emitting areas PXA1a, PXA2a, and PXA3a and the non-light emitting area NPXA may be defined in a display panel DPb. The light emitting areas PXA1a, PXA2a, and PXA3a may include a first light emitting area PXA1a, a second light emitting area PXA2a, and a third light emitting area PXA3a.

A pixel defining layer PDLa may include a first pixel defining layer PDL1 surrounding the light emitting areas PXA1a, PXA2a, and PXA3a in a plan view, and a second pixel defining layer PDL2 surrounded by each of the light emitting areas PXA1a, PXA2a, and PXA3a in a plan view. The first light emitting area PXA1a may be defined by a first opening PDL-OP1a defined in the first pixel defining layer PDL1 and the second pixel defining layer PDL2. The second light emitting area PXA2a may be defined by a second opening PDL-OP2a defined in the first pixel defining layer PDL1 and the second pixel defining layer PDL2. The third light emitting area PXA3a may be defined by a third opening PDL-OP3a defined in the first pixel defining layer PDL1 and the second pixel defining layer PDL2. The pixel defining layer PDL1 and the second pixel defining layer PDL2 may overlap the non-light emitting area NPXA in a plan view.

A separator SRa may include a first separator SR1 disposed on the first pixel defining layer PDL1 and a second separator SR2 disposed on the second pixel defining layer PDL2. The first pixel defining layer PDL1 and the first separator SR1 may function as a first partition wall, and the second pixel defining layer PDL2 and the second separator SR2 may function as a second partition wall. The first separator SR1 may correspond to the separator SR shown in FIG. 7. Each of the second separator SR2 and the first separator SR1 may have a reversed tapered shape in a cross-sectional view. Accordingly, the second separator SR2 may be disposed on the second pixel defining layer PDL2 to partially disconnect the intermediate layer ML. A width of the second separator SR2 in the second direction DR2 may be less than a width of the first separator SR1 in the second direction DR2. A sufficient size of the first light emitting area PXA1a may be secured by making the width of the second separator SR2 in the second direction DR2 small.

An auxiliary electrode SEc may include a first auxiliary electrode SE1 disposed on the first separator SR1 and a second auxiliary electrode SE2 disposed on the second separator SR2. The first auxiliary electrode SE1 may correspond to the auxiliary electrode SE shown in FIG. 6. Each of the first auxiliary electrode SE1 and the second auxiliary electrode SE2 may contain a reflective material. The second auxiliary electrode SE2 and the first auxiliary electrode SE1 may have a shapes corresponding to the shapes of the second separator SR2 and the first separator SR1, respectively, in a cross-sectional view. A width of the second separator SR2 in the second direction DR2 and a width of the first separator SR1 in the second direction DR2 may be different from each other. For example, the width of the second separator SR2 in the second direction DR2 may be less than the width of the first separator SR1 in the second direction DR2. The disclosure is not limited thereto, and the auxiliary electrode SEc may be disposed only on one of the first separator SR1 and the second separator SR2.

According to one embodiment, as the first auxiliary electrode SE1 containing the reflective material is disposed on side surfaces of the first separator SR1 and the second auxiliary electrode SE2 containing the reflective material is disposed on side surfaces of the second separator SR2, the light Lg (see FIG. 8) emitted from the light emitting layer included in the intermediate layer ML to the first auxiliary electrode SE1 or the second auxiliary electrode SE2 may be reflected from the first auxiliary electrode SE1 or the second auxiliary electrode SE2 and emitted to the outside of the display device DD (see FIG. 1). As a result, the display device DD with the increased light emission efficiency may be provided.

A dummy layer DMLa may include a first dummy layer DML1 disposed on the first auxiliary electrode SE1 and a second dummy layer DMI,2 disposed on the second auxiliary electrode SE2. The first dummy layer DMI,1 and the second dummy layer DMI,2 and the intermediate layer ML may be formed via a same process. Accordingly, the first dummy layer DML1 and the second dummy layer DML2 and the intermediate layer ML may contain a same material.

The second electrode CE may be electrically connected to the first auxiliary electrode SE1 and the second auxiliary electrode SE2. For example, the intermediate layer ML may be disconnected by the first separator SR1 and the second electrode CE and the first auxiliary electrode SE1 may contact with and be electrically connected to each other in the disconnected area, and the intermediate layer ML may be disconnected by the second separator SR2 and the second electrode CE and the second auxiliary electrode SE2 may contact with and be electrically connected to each other in the disconnected area.

In one embodiment, each of the first auxiliary electrode SE1 and the second auxiliary electrode SE2 may contain one of the materials that can be used for the second electrode CE. Accordingly, the second electrode CE may directly contact with and be electrically connected to each of the first auxiliary electrode SE1 and the second auxiliary electrode SE2.

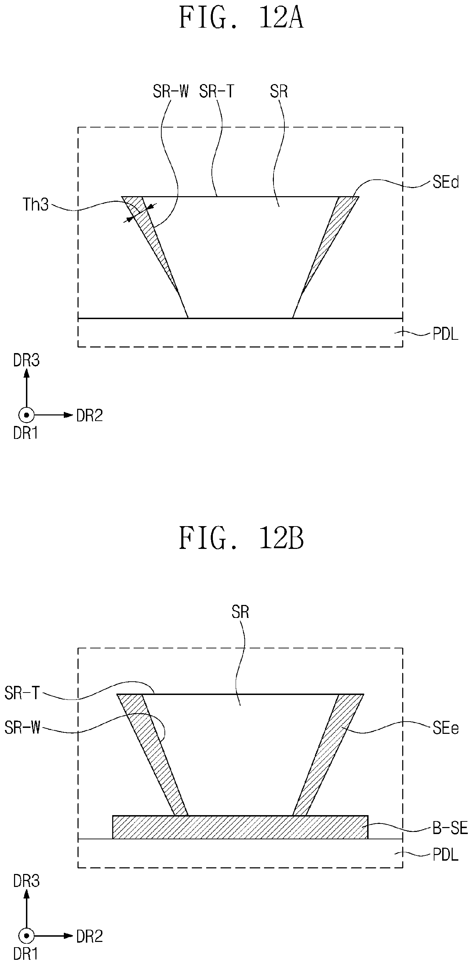

FIG. 12A is a schematic enlarged cross-sectional view of a separator and an auxiliary electrode according to an embodiment of the disclosure.

Referring to FIG. 12A, an auxiliary electrode SEd may be disposed on both of the side surfaces SR-W of the separator SR. The auxiliary electrode SEd may be disposed to cover both of the side surfaces SR-W of the separator SR. Compared with the auxiliary electrode SEa shown in FIG. 9A, the auxiliary electrode SEd shown in FIG. 12A may not include the upper auxiliary electrode T-SE. For example, the auxiliary electrode SEd may be formed by patterning the upper auxiliary electrode T-SE using a separate mask after forming the auxiliary electrode SEa shown in FIG. 9A. As a result, a phenomenon in which light incident from the outside of the display device DD (see FIG. 1) is reflected from the upper auxiliary electrode T-SE and viewed by the user may be prevented.

As the auxiliary electrode SEd becomes closer to the pixel defining layer PDL, a thickness Th3 of the auxiliary electrode Sed in a normal direction of the side surface SR-W of the separator SR may become smaller. Because the separator SR has the reversed tapered shape, as the pixel defining layer PDL becomes closer, it may become difficult for the deposition material to be deposited on the side surface SR-W of the separator SR by the top surface SR-T of the separator SR, so that the thickness Th3 of the auxiliary electrode SEd may become smaller.

FIG. 12B is a schematic enlarged cross-sectional view of a separator, an auxiliary electrode, and a lower auxiliary electrode according to an embodiment of the disclosure.

Referring to FIG. 12B, an auxiliary electrode SEe may be disposed on the side surfaces SR-W of the separator SR to cover the entirety of the side surfaces SR-W of the separator SR.

The lower auxiliary electrode B-SE may be disposed between the separator SR and the pixel defining layer PDL. The lower auxiliary electrode B-SE may directly be in contact with each of the bottom surface of the separator SR and the auxiliary electrode SEe. According to one embodiment of the disclosure, the auxiliary electrode SEe and the lower auxiliary electrode B-SE may contain a same material. For example, each of the auxiliary electrode SEe and the lower auxiliary electrode B-SE may contain a reflective material. However, the disclosure is not limited thereto, and the lower auxiliary electrode B-SE may not contain a reflective material. For example, the lower auxiliary electrode B-SE may contain a metal material that may be electrically connected to the auxiliary electrode SEe. Accordingly, the lower auxiliary electrode B-SE and the auxiliary electrode SEe may be electrically connected to each other.

In the display device of the disclosure, as the auxiliary electrode containing a reflective material is disposed on the side surfaces of the separator, light emitted from the light emitting layer may be reflected from the auxiliary electrode and be readily emitted to the outside of the display device. As a result, the display device with the improved light emission efficiency may be provided.

The above description is an example of technical features of the disclosure, and those skilled in the art to which the disclosure pertains will be able to make various modifications and variations. Therefore, the embodiments of the disclosure described above may be implemented separately or in combination with each other. The present invention will now be defined with reference to the following clauses.

Clause 1. A display device comprising:
a circuit layer disposed on a base substrate; and
a display element layer disposed on the circuit layer, wherein
the display element layer includes:
   a light emitting element;
   a pixel defining layer defining a light emitting area of the light emitting element;
   a separator disposed on the pixel defining layer; and
   an auxiliary electrode disposed on the separator and including a reflective material,
   the auxiliary electrode is electrically connected to an electrode of the light emitting element,
   a side surface of the separator is inclined toward the light emitting element, and the auxiliary electrode covers the side surface of the separator.

Clause 2. The display device of clause 1, wherein the auxiliary electrode includes:
an upper auxiliary electrode disposed on a top surface of the separator; and
a side auxiliary electrode disposed on the side surface of the separator.

Clause 3. The display device of clause 2, wherein a thickness of the upper auxiliary electrode and a thickness of the side auxiliary electrode are different from each other.

Clause 4. The display device of clause 3, wherein the thickness of the upper auxiliary electrode is greater than the thickness of the side auxiliary electrode.

Clause 5. The display device of any one of clauses 2 to 4, wherein a thickness of the side auxiliary electrode becomes smaller as the side auxiliary electrode gets closer to the pixel defining layer.

Clause 6. The display device of any one of clauses 1 to 5, wherein the display element layer further includes a lower auxiliary electrode disposed between the separator and the pixel defining layer.

Clause 7. The display device of clause 6, wherein the auxiliary electrode and the lower auxiliary electrode include a same material.

Clause 8. The display device of clause 7, wherein the auxiliary electrode and the lower auxiliary electrode are electrically connected to each other.

Clause 9. The display device of any one of clauses 1 to 8, wherein the pixel defining layer includes:
a first pixel defining layer surrounding the light emitting area in a plan view; and
a second pixel defining layer surrounded by the light emitting area in a plan view.

Clause 10. The display device of clause 9, wherein the separator includes:
a first separator disposed on the first pixel defining layer; and
a second separator disposed on the second pixel defining layer.

Clause 11. The display device of clause 10, wherein the auxiliary electrode is disposed on at least one of the first separator and the second separator.

Clause 12. The display device of clause 11, wherein the auxiliary electrode includes:
a first auxiliary electrode disposed on the first separator; and
a second auxiliary electrode disposed on the second separator, and
the first auxiliary electrode and the second auxiliary electrode are electrically connected to each other.

Clause 13. The display device of any one of clauses 1 to 12, wherein the auxiliary electrode includes a metal.

Clause 14. The display device of any one of clauses 1 to 13, wherein the light emitting element includes:
a first electrode;
an intermediate layer disposed on the first electrode; and
a second electrode electrically connected to the auxiliary electrode.

Clause 15. The display device of clause 14, wherein the intermediate layer is disconnected by the separator.

Clause 16. The display device of clause 14 or clause 15, wherein the first electrode partially overlaps the pixel defining layer in a plan view.

Clause 17. The display device of clause 16, wherein the pixel defining layer includes a light-transmissive material.

Clause 18. The display device of any one of clauses 1 to 17, wherein an angle between the side surface of the separator and a top surface of the pixel defining layer is in a range of about 70 ° to about 80 °.

Clause 19. The display device of any one of clauses 1 to 18, wherein the circuit layer includes an auxiliary wire that applies a driving voltage to the light emitting element, and
the auxiliary electrode and the auxiliary wire are electrically connected to each other.

Clause 20. A display device comprising:
a circuit layer disposed on a base substrate;
a light emitting element disposed on the circuit layer and corresponding to a light emitting area;
a partition wall disposed on the circuit layer and disposed to correspond to a non-light emitting area adjacent to the light emitting area; and an auxiliary electrode disposed on the partition wall and including a reflective material, wherein
the auxiliary electrode is electrically connected to an electrode of the light emitting element,
the partition wall includes a first partition wall surrounding the light emitting element in a plan view and a second partition wall surrounded by the light emitting element in a plan view, and
the auxiliary electrode is disposed on at least one of the first partition wall and the second partition wall.

Clause 21. The display device of clause 20, wherein the partition wall further includes:
a pixel defining layer defining the light emitting area of the light emitting element; and
a separator disposed on the pixel defining layer.

Clause 22. The display device of clause 21, wherein
a side surface of the separator is inclined toward the light emitting element, and the auxiliary electrode covers the side surface of the separator.

Clause 23. The display device of clause 22, wherein an angle between the side surface of the separator and a top surface of the pixel defining layer is in a range of about 70 ° to about 80 °.

Clause 24. The display device of any one of clauses 21 to 23, wherein the light emitting element includes:
a first electrode;
an intermediate layer disposed on the first electrode; and a second electrode electrically connected to the auxiliary electrode.

Clause 25. The display device of clause 24, wherein the intermediate layer is disconnected by the separator.

Clause 26. The display device of clause 24, wherein the first electrode partially overlaps the pixel defining layer in a plan view.

Clause 27. The display device of clause 26, wherein the pixel defining layer includes a light-transmissive material.

Clause 28. The display device of any one of clauses 20 to 27, wherein the auxiliary electrode includes:
a first auxiliary electrode disposed on the first partition wall; and
a second auxiliary electrode disposed on the second partition wall, and
the first auxiliary electrode and the second auxiliary electrode are electrically connected to each other.

Clause 29. A display device comprising:
a circuit layer disposed on a base substrate;
a light emitting element disposed on the circuit layer and corresponding to a light emitting area;
a partition wall disposed on the circuit layer, disposed corresponding to a non-light emitting area adjacent to the light emitting area, and including a first portion and a second portion having a greater thickness than a thickness of the first portion; and
an auxiliary electrode disposed on the second portion of the partition wall and including a reflective material,
wherein the auxiliary electrode is electrically connected to an electrode of the light emitting element.

## Claims

1. A display device comprising:
a circuit layer disposed on a base substrate; and
a display element layer disposed on the circuit layer, wherein
the display element layer includes:
a light emitting element;
a pixel defining layer defining a light emitting area of the light emitting element;
a separator disposed on the pixel defining layer; and
an auxiliary electrode disposed on the separator and including a reflective material,
the auxiliary electrode is electrically connected to an electrode of the light emitting element,
a side surface of the separator is inclined toward the light emitting element, and
the auxiliary electrode covers the side surface of the separator.

2. The display device of claim 1, wherein the auxiliary electrode includes:
an upper auxiliary electrode disposed on a top surface of the separator; and
a side auxiliary electrode disposed on the side surface of the separator.

3. The display device of claim 2, wherein a thickness of the upper auxiliary electrode and a thickness of the side auxiliary electrode are different from each other, optionally wherein the thickness of the upper auxiliary electrode is greater than the thickness of the side auxiliary electrode.

4. The display device of claim 2 or claim 3, wherein a thickness of the side auxiliary electrode becomes smaller as the side auxiliary electrode gets closer to the pixel defining layer.

5. The display device of any one of claims 1 to 4, wherein the display element layer further includes a lower auxiliary electrode disposed between the separator and the pixel defining layer, optionally wherein the auxiliary electrode and the lower auxiliary electrode include a same material, more optionally wherein the auxiliary electrode and the lower auxiliary electrode are electrically connected to each other.

6. The display device of any one of claims 1 to 5, wherein the pixel defining layer includes:
a first pixel defining layer surrounding the light emitting area in a plan view; and
a second pixel defining layer surrounded by the light emitting area in the plan view.

7. The display device of claim 6, wherein the separator includes:
a first separator disposed on the first pixel defining layer; and
a second separator disposed on the second pixel defining layer,
optionally wherein the auxiliary electrode is disposed on at least one of the first separator and the second separator, more optionally wherein
the auxiliary electrode includes:
a first auxiliary electrode disposed on the first separator; and
a second auxiliary electrode disposed on the second separator, and
the first auxiliary electrode and the second auxiliary electrode are electrically connected to each other.

8. The display device of any one of claims 1 to 7, wherein the auxiliary electrode includes a metal.

9. The display device of any one of claims 1 to 8, wherein the light emitting element includes:
a first electrode;
an intermediate layer disposed on the first electrode; and
a second electrode electrically connected to the auxiliary electrode, optionally:
wherein the intermediate layer is disconnected by the separator.

10. The display device of claim 9, wherein the first electrode partially overlaps the pixel defining layer in a plan view, optionally wherein the pixel defining layer includes a light-transmissive material.

11. The display device of any one of claims 1 to 10, wherein:
(i) an angle between the side surface of the separator and a top surface of the pixel defining layer is in a range of about 70 ° to about 80 °; and/or
(ii) the circuit layer includes an auxiliary wire that applies a driving voltage to the light emitting element, and the auxiliary electrode and the auxiliary wire are electrically connected to each other.

12. A display device comprising:
a circuit layer disposed on a base substrate;
a light emitting element disposed on the circuit layer and corresponding to a light emitting area;
a partition wall disposed on the circuit layer and disposed to correspond to a non-light emitting area adjacent to the light emitting area; and
an auxiliary electrode disposed on the partition wall and including a reflective material, wherein
the auxiliary electrode is electrically connected to an electrode of the light emitting element,
the partition wall includes a first partition wall surrounding the light emitting element in a plan view and a second partition wall surrounded by the light emitting element in the plan view, and
the auxiliary electrode is disposed on at least one of the first partition wall and the second partition wall.

13. The display device of claim 12, wherein the partition wall further includes:
a pixel defining layer defining the light emitting area of the light emitting element; and
a separator disposed on the pixel defining layer, optionally wherein
a side surface of the separator is inclined toward the light emitting element, and
the auxiliary electrode covers the side surface of the separator,
more optionally wherein an angle between the side surface of the separator and a top surface of the pixel defining layer is in a range of about 70 ° to about 80 °.

14. The display device of claim 13, wherein the light emitting element includes:
a first electrode;
an intermediate layer disposed on the first electrode; and
a second electrode electrically connected to the auxiliary electrode.

15. The display device of claim 14, wherein:
(i) the intermediate layer is disconnected by the separator; and/or
(ii) the first electrode partially overlaps the pixel defining layer in the plan view, optionally wherein the pixel defining layer includes a light-transmissive material.

16. The display device of any one of claims 12 to 15, wherein
the auxiliary electrode includes:
a first auxiliary electrode disposed on the first partition wall; and
a second auxiliary electrode disposed on the second partition wall, and
the first auxiliary electrode and the second auxiliary electrode are electrically connected to each other.

17. A display device comprising:
a circuit layer disposed on a base substrate;
a light emitting element disposed on the circuit layer and corresponding to a light emitting area;
a partition wall disposed on the circuit layer, disposed corresponding to a non-light emitting area adjacent to the light emitting area, and including a first portion and a second portion having a greater thickness than a thickness of the first portion; and
an auxiliary electrode disposed on the second portion of the partition wall and including a reflective material,
wherein the auxiliary electrode is electrically connected to an electrode of the light emitting element.
